# EUROPÄISCHE PATENTANMELDUNG

(11) **EP 0 915 345 A2**
(43) Veröffentlichungstag der Anmeldung: **12.05.1999**
(21) Anmeldenummer: 98811059.9
(22) Anmeldetag: 22.10.1998
(51) Int. Cl.: G01R 15/18

(54) **Elektrischer Apparat, insbesondere Ueberspannungsableiter, mit einer Vorrichtung zur Anzeige eines Fehlerstroms**

(30) Priorität: 08.11.1997 DE 19749523
(71) Anmelder: Asea Brown Boveri AG, 5401 Baden (CH)
(72) Erfinder: Schmidt, Walter, 5454 Bellikon (CH)
(74) Vertreter: Kaiser, Helmut

(57) **Zusammenfassung**

Der vorzugsweise als Überspannungsableiter (3) ausgebildete elektrische Apparat weist eine einen Stromsensor enthaltende Vorrichtung zur Anzeige eines durch einen Fehlerstrom (I) verursachten fehlerhaften Zustands auf. In der Anzeigevorrichtung ist ferner ein von Erdpotential aus bedienbarer Empfänger (Lesestation 9) für elektromagnetische Wellen vorgesehen sowie ein mit dem Stromsensor zusammenwirkender und elektromagnetische Wellen an den Empfänger (9) abstrahlender Informationsträger (8).

Bei einem solchen Apparat kann der fehlerhafte Zustand unabhängig von optischen Signalen erkannt werden.

## Beschreibung

### TECHNISCHES GEBIET

Bei der Erfindung wird ausgegangen von einem elektrischen Apparat, insbesondere einem Überspannungsableiter, nach dem Oberbegriff von Patentanspruch 1.

### STAND DER TECHNIK

Die Erfindung nimmt auf einen Stand der Technik von elektrischen Apparaten Bezug, wie er in EP 0 564 334 A1 angegeben ist. Ein in diesem Stand der Technik beschriebener elektrischer Apparat, welcher vorzugsweise als Überspannungsableiter oder als Isolator für Hoch- oder Mittelspannungsnetze ausgebildet ist, enthält eine der Überwachung des elektrischen Apparates auf einen Fehlerstrom dienende Erfassungs- und Anzeigevorrichtung. Diese Vorrichtung weist ein Isolierstoffgehäuse mit einem leicht zerbrechbaren Fenster auf. Durch das Isolierstoffgehäuse hindurch ist ein Stromanschluss des elektrischen Apparates geführt. Der im Gehäuseinneren befindliche Teil des Stromanschlusses ist von einem Magnetkern umgeben, welcher die Sekundärwicklung eines den Stromanschluss als Primärwicklung aufweisenden Stromwandlers trägt. Die Sekundärwicklung ist mit einem ohmschen Widerstand verbunden, der in eine im Gehäuseinneren angeordnete Sprengstoffladung eingebettet ist. Beim Auftreten eines Fehlerstroms erwärmt sich der vom Stromwandler kontinuierlich mit Strom gespeiste ohmsche Widerstand sehr stark. Der Widerstand zündet die Sprengstoffladung oberhalb einer kritischen Grenztemperatur. Das Fenster des Isolierstoffgehäuses wird hierbei aufgebrochen und ein als Anzeigelement dienendes farbiges Band aus dem Gehäuse ausgestossen. Nach dem Ansprechen und dem optischen Signalisieren des fehlerhaften Zustands werden der elektrische Apparat und die Erfassungs- und Anzeigevorrichtung ausgebaut und ersetzt.

In einem Aufsatz von R.Stierlin "Technologietransfer führt zu cleveren SAW-Tags" Management Zeitschrift 63 (1994) Nr.11, Verlag Industrielle Organisation BWI ETH - Zürichbergstrasse 18, CH-8028 Zürich, sind Informationsträger (Tags) beschrieben, welche an ein mobiles Objekt, etwa ein Fahrzeug oder einen Behälter, geheftet werden. Gerät ein solcher Tag in den Erfassungsbereich einer Lesestation, erkennt diese Station die vom Tag getragene Information und identifiziert so das mobile Objekt. Dieser Tag bezieht im allgemeinen Energie aus einer Batterie oder aus elektromagnetischen Wellen, insbesondere Mikrowellen, und sendet an das Lesegerät die Information enthaltende elektromagnetische Wellen aus. Zu diesem Zweck weist der Tag eine Antenne zum Abstrahlen und gegebenenfalls zum Empfang der elektromagnetischen Wellen auf sowie ein mit der Antenne über einen Stromleiter verbundenes Bauteil auf Halbleiterbasis, in das das mobile Objekt betreffende Daten eingespeichert sind. Das Bauteil kann als sogenanntes SAW-Tag (SAW = surface acoustic wave) ausgebildet sein. Es nimmt dann vom Lesegerät ausgesendete und über die Antenne empfangene Signale auf Mikrowellenbasis auf, wandelt diese Signale in akustische Signale um und erlaubt so eine analoge Signalverarbeitung auf minimalem Platz. Zudem benötigt ein solches SAW-Tag keine interne Energiequelle, wie eine Batterie, sondern bezieht seine Energie aus der vom Lesegerät abgestrahlten Leistung.

### DARSTELLUNG DER ERFINDUNG

Der Erfindung, wie sie in den Patentansprüchen angegeben ist, liegt die Aufgabe zugrunde, einen elektrischen Apparat der eingangs genannten Art anzugeben, welcher sich bei einfachem Aufbau vor allem dadurch auszeichnet, dass der fehlerhafte Zustand des elektrischen Apparates auch bei ungünstigen Lichtverhältnissen rasch und leicht erkannt werden kann.

Beim elektrischen Apparat nach der Erfindung wird ein durch einen Fehlerstrom verursachter fehlerhafter Betriebszustand unabhängig von einem optischen Signalgeber durch einen als Stromsensor wirkenden Informationsträger angezeigt.

Der nach der Einwirkung des Fehlerstroms modifizierte Informationsträger und damit auch der mit dem Informationsträger versehene fehlerhafte elektrische Apparat können so vom Wartungspersonal bei Dunkelheit oder Nebel selbst in Entfernungen von bis zu 100 m mit grosser Zuverlässigkeit und in kurzer Zeit identifiziert werden.

### KURZE BESCHREIBUNG DER ZEICHNUNGEN

Ein bevorzugtes Ausführungsbeispiel der Erfindung und die damit erzielbaren weiteren Vorteile werden nachfolgend anhand von Zeichnungen näher erläutert. Hierbei zeigt:
- Fig. 1: einen Phasenleiter einer Hochspannungsleitung, welcher mit einem als Überspannungsableiter ausgeführten und eine Vorrichtung zur Anzeige von Fehlerströmen enthaltenden elektrischen Apparat nach der Erfindung elektrisch leitend verbunden ist,
- Fig.2: ein Blockschaltbild einer ersten Ausführungsform der Anzeigevorrichtung des Überspannungsableiters gemäss Fig.1, und
- Fig.3: ein Blockschaltbild einer zweiten Ausführungsform der Anzeigevorrichtung des Überspannungsableiters gemäss Fig.1.

### WEG ZUR AUSFÜHRUNG DER ERFINDUNG

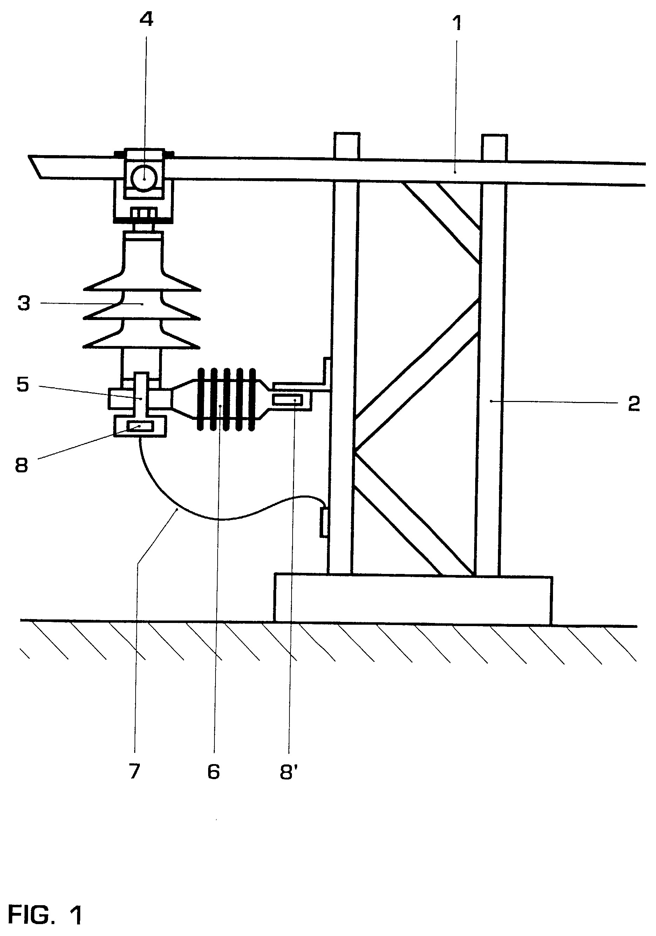

In den Figuren 1 bis 3 bezeichnen gleiche Bezugszeichen auch gleichwirkende Teile. Das Bezugszeichen 1 bezeichnet einen Phasenleiter einer an einem geerdeten Mast 2 elektrisch isoliert gehaltenen Hochspannungsleitung. Am Phasenleiter 1 ist ein Überspannungsableiter 3 aufgehängt. Der Überspannungsableiter 3 ist mit einem Stromanschluss 4 mit dem Phasenleiter 1 galvanisch verbunden und ist mit Hilfe eines Stützisolators 6 am Mast 2 befestigt. Ein zweiter Stromanschluss 5 des Überspannungsableiters 3 ist über ein Erdungskabel 7 mit dem Mast 2 galvanisch verbunden.

Am Stromanschluss 5 oder an einem anderen im Betrieb gegebenenfalls einem unerwünscht grossen Fehlerstrom oder zumindest der induktiven Wirkung des Fehlerstroms ausgesetzten Teil des Uberspannungsableiters 3 ist ein Informationsträger 8 einer Vorrichtung zur Anzeige des Fehlerstroms befestigt. Der Informationsträger 8 kann durch eine beliebige Verbindung, etwa durch Stecken, Kleben oder Schrauben, am Stromanschluss 5 oder einem anderen im Fehlerfall stromführenden Teil des Überspannungsableiters, etwa dem Stromanschluss 4, angeordnet sein.

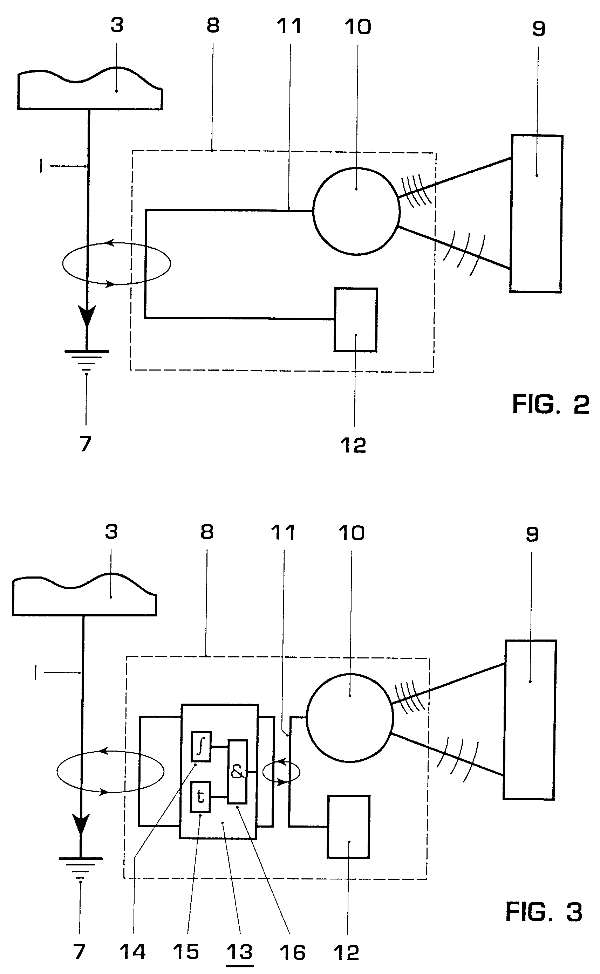

Eine in Fig.2 schematisch dargestellte erste Ausführungsvorrichtung der Anzeigevorrichtung enthält neben dem Informationsträger 8 auch einen als mobile Lesestation 9 für Signale auf der Basis von elektromagnetische Wellen ausgebildeten Empfänger. Die Lesestation 9 wird vom Wartungspersonal der Hochspannungsleitung bei der Fehlersuche an den fehlerbehafteten Leitungsabschnitt gebracht und dort zur Lokalisierung des fehlerbehafteten elektrischen Apparates verwendet.

Die von der Lesestation 9 empfangenen Signale werden im Informationsträger 8 gebildet. Die hierzu notwendige Energie kann einer beispielsweise als Batterie ausgebildeten Stromquelle des Informationsträgers 8 entnommen werden, kann aber auch über elektromagnetische Wellen, welche mit Vorteil in der Lesestation 9 gebildet werden, in den Informationsträger 8 eingespeist werden. Der Informationsträger 8 weist eine Antenne 10 zum Abstrahlen der elektromagnetischen Wellen auf sowie ein über einen Stromleiter 11 Informationssignale in die Antenne 10 speisendes Bauteil 12.

Vorteilhafterweise ist das Bauteil 12 als SAW-Tag ausgeführt. Von der Lesestation 9 ausgestrahlte Mikrowellen werden dann von der Antenne 10 in den Informationsträger 8 eingekoppelt und treten über den Stromleiter 11 in Wechselwirkung mit dem als SAW-Tag ausgeführten Bauteil 12. Hierbei nehmen sie im Bauteil 12 gespeicherte Informationen auf und werden schliesslich als informationstragende Signale über die Antenne 10 in Form von Mikrowellen vom Informationsträger 8 abgestrahlt und von der Lesestation 9 empfangen. Eine üblicherweise als Batterie ausgeführte Energiequelle für den Informationsträger 8 kann so entfallen.

Der vorteilhafterweise in Streifenform ausgeführte und vorzugsweise auf einer Printplatte angebrachte Stromleiter 11 ist Teil eines den Fehlerstrom I erfassenden Stromsensors. Der Stromleiter 11 kann in galvanischem Kontakt mit dem im Fehlerfall stromführenden Teil des Überspannungsableiters stehen, kann aber auch elektrisch isoliert gegenüber dem gegebenenfalls stromführenden Teil angeordnet sein. Wichtig ist vor allem, dass beim Auftreten eines durch den Überspannungsableiter 3 fliessenden Fehlerstroms I zumindest ein Teil des Stroms I in den Stromleiter 3 geführt wird, oder dass der Fehlerstrom I im Stromleiter 11 einen Strom induziert, welcher durch Zerstörung des Stromleiters 11 oder eines anderen Teils des Informationsträger 8 oder durch Beinflussung des Datentransfers im Informationsträger 8, eine Veränderung des Informationsträgers 8 bewirkt. Von der Lesestation 9 wird dann ein Signal empfangen, welches den veränderten Zustand des Informationsträger 8 erkennt und damit den fehlerbehafteten Ableiter unabhängig von den optischen Bedingungen identifiziert. Der defekte Überspannungsableiter kann dann ausgebaut und durch einen neuen Ableiter mit einem neuen Informationsträger ersetzt werden.

Statt an einem Überspannungsableiter kann der Informationsträger auch an einem anderen elektrischen Apparat, beispielsweise einem Isolator eines Schalters oder eines Transformators, oder einem Isolator einer Hochspannungsanlage, beispielsweise dem Stützisolator 6 ( Informationsträger 8' gemäss Fig.1), befestigt sein. Die mit dem Informationsträger 8 bzw 8' zusammenwirkende Lesestation 9 kann in jedem Fall aus der von ihr aufgenommenen Impulsantwort erkennen, ob der von ihr abgefragte elektrische Apparat fehlerfrei oder fehlerbehaftet ist.

Da bestimmte elektrische Apparate, wie insbesondere der Überspannungsableiter 3, so ausgelegt sind, dass sie im Betrieb kontinuierlich einen Leckstrom vorgegebener Grösse oder kurzzeitig einen hohen Stossstrom führen, empfiehlt es sich, den Fehlerstrom I nicht unmittelbar, sondern wie in der Ausführungsform gemäss Fig.3 dargestellt ist, über einen im Stromsensor vorgesehenen Diskriminator 13 in den Stromleiter 11 des Informationsträgers 8 einzukoppeln. Der Diskriminator 13 weist dann einen Schwellwertdetektor 14 für die Stromamplitude und einen die Dauer des Stroms erfassenden Zeitintegrator 15 auf sowie ein UND-Glied 16, welches die Ausgangssignale von Schwellwertdetektor 14 und Zeitintegrator 15 erfasst und miteinander verknüpft. Ein fehlerstromproportionales Signal wird erst dann vom Diskriminator 13 in den Informationsträger 8 eingekoppelt, wenn sowohl die Stromamplitude als auch die Zeit, während der der Strom fliesst, jeweils einen durch die Betriebsdaten des Ableiters bestimmten Grenzwert überschritten haben.

### BEZUGSZEICHENLISTE

- 1: Phasen leiter
- 2: Mast
- 3: Überspannungsableiter
- 4, 5: Stromanschlüsse
- 6: Stützisolator
- 7: Erdungskabel
- 8: Informationsträger
- 9: Lesestation
- 10: Antenne
- 11: Stromleiter
- 12: Bauteil
- 13: Diskriminator
- 14: Schwellwertdetektor
- 15: Zeitintegrator
- 16: UND-Glied

## Patentansprüche

1. Elektrischer Apparat, insbesondere Überspannungsableiter (3), mit einer einen Stromsensor enthaltenden Vorrichtung zur Anzeige eines durch einen Fehlerstrom (I) verursachten fehlerhaften Zustands, dadurch gekennzeichnet, dass die Anzeigevorrichtung einen auf Erdpotential befindlichen Empfänger (9) für elektromagnetische Wellen aufweist sowie einen mit dem Stromsensor zusammenwirkenden und elektromagnetische Wellen an den Empfänger abstrahlenden Informationsträger (8).

2. Elektrischer Apparat nach Anspruch 1, dadurch gekennzeichnet, dass der Informationsträger (8) als Tag ausgebildet ist und eine mit dem Empfänger (9) zusammenwirkende Antenne (10) sowie ein von der Antenne (10) gespeistes und in die Antenne (10) speisendes Bauteil (12) aufweist.

3. Elektrischer Apparat nach Anspruch 2, dadurch gekennzeichnet, dass das Bauteil (12) als SAW-Tag ausgeführt ist.

4. Elektrischer Apparat nach einem der Ansprüche 2 oder 3, dadurch gekennzeichnet, dass das Bauteil (12) mit der Antenne (10) über einen Stromleiter (11) verbunden ist, welcher Teil des Stromsensors ist.

5. Elektrischer Apparat nach einem der Ansprüche 3 oder 4, dadurch gekennzeichnet, dass der Stromleiter (11) der induktiven Wirkung des Fehlerstroms (I) ausgesetzt ist oder zumindest einen Teil des Fehlerstroms führt.

6. Elektrischer Apparat nach einem der Ansprüche 3 oder 4, dadurch gekennzeichnet, dass der Stromsensor einen auf den Stromleiter (11) wirkenden Diskriminator (13) enthält.

7. Elektrischer Apparat nach Anspruch 6, dadurch gekennzeichnet, dass der Diskriminator (13) einen Schwellwertdetektor (14) für die Stromamplitude, einen Zeitintegrator (15) sowie ein die Ausgangssignale von Schwellwertdetektor (14) und Zeitintegrator (15) verknüpfendes UND-Glied (16) enthält.

8. Elektrischer Apparat nach einem der Ansprüche 1 bis 7, dadurch gekennzeichnet, dass der Informationsträger (8) an einem von aussen zugänglichen Teil des elektrischen Apparates befestigt ist.
